# EUROPÄISCHE PATENTSCHRIFT

(11) **EP 2 809 079 B1**
(45) Veröffentlichungstag und Bekanntmachung des Hinweises auf die Patenterteilung: **12.07.2017**
(21) Anmeldenummer: 13169695.7
(22) Anmeldetag: 29.05.2013
(51) Int. Cl.: H04Q 9/00, G01R 31/36, H01M 10/42, H01M 10/48

(54) **Batteriesystem und Verfahren zur Steuerung eines Batteriesystems**
Battery system and method for controlling a battery system
Système de batterie et procédé de commande d'un système de batterie

(43) Veröffentlichungstag der Anmeldung: 03.12.2014
(73) Patentinhaber: Samsung SDI Co., Ltd, Gyeonggi-do 17084 (KR)
(72) Erfinder: Hausberger, Ingo, 9433 St. Andrä (AT); Klobasa, Roland, 8051 Graz (AT); Korherr, Thomas, 8230 Hartberg (AT)
(74) Vertreter: Gulde & Partner

(56) Entgegenhaltungen:
- EP-A1- 2 385 604
- DE-A1-102011 113 798
- US-A1- 2010 146 318

## Beschreibung

### Gebiet der Erfindung

Die vorliegende Erfindung betrifft ein Batteriesystem umfassend mehrere Batteriezellen, eine Steuerungs-Elektronikeinheit mit einem Steuerungsprozessor zur Steuerung des Batteriesystems, und zumindest eine Überwachungs-Elektronikeinheit mit einem Überwachungsprozessor zur Erfassung und Beeinflussung der Spannung zumindest einiger der Batteriezellen des Batteriesystems. Die Erfindung betrifft auch ein Verfahren zur Steuerung eines Batteriesystems.

### Stand der Technik

Derartige Batteriesysteme werden beispielsweise für Elektro- und Hybridfahrzeuge genutzt, insbesondere als Hochvolt-Batteriesysteme, die üblicherweise eine Vielzahl von Batteriezellen umfassen, deren Ladezustand überwacht und beeinflusst werden kann. Hierzu kann eine zentrale Steuerungs-Elektronikeinheit als Batteriesteuerungseinheit (Battery Management Unit, BMU) ausgeführt sein, die insbesondere den Gesamtzustand des Batteriesystems kontrolliert und beispielsweise einen Ladungsausgleich zwischen den Batteriezellen anfordert. Zusätzlich werden häufig als Überwachungs-Elektronikeinheiten lokale Zellüberwachungseinheiten (Cell Supervisory Controller, CSC) eingesetzt, die beispielsweise für jede einzelne Batteriezelle oder für Gruppen von Batteriezellen Zustände wie Zellspannung und Temperatur erfassen und an die Batteriesteuerungseinheit kommunizieren. Zwischen der Batteriesteuerungseinheit und den Zellüberwachungseinheiten ist üblicherweise eine Kommunikationsverbindung, beispielsweise als Controller Area Network-Bus (CAN-Bus), als Serial Peripheral Interface-Bus (SPI-Bus) oder als proprietärer Bus eingerichtet.

Bei derartigen Überwachungs-Elektronikeinheiten beziehungsweise deren Überwachungsprozessoren kann es jedoch zu Fehlfunktionen und Fehlerzuständen kommen, so dass beispielsweise ein Überwachungsprozessor keine Befehle vom übergeordneten Steuerungsprozessor mehr annimmt oder ausführt. Eine Steuerung der untergeordneten Einheit und damit eine Kontrolle der der Überwachungs-Elektronikeinheit zugeordneten Batteriezellen ist dadurch nicht mehr möglich.

Aus der EP 2 385 604 A1 ist ein Verfahren bekannt zur Überwachung eines Akkumulators mit mehreren Zellen, bei dem ein Parameter einer Zelle gemessen und an eine zentrale Überwachungseinheit übermittelt wird. Durch ein impulsförmiges Reset-Signal auf einer Leitung einer Zellüberwachungseinheit werden alle D-Flip-Flops zurückgesetzt.

### Zusammenfassung der Erfindung

Es ist eine Aufgabe der Erfindung, Batteriesysteme der genannten Art in dieser Hinsicht zu verbessern und insbesondere ein Batteriesystem und ein Verfahren zum Betrieb eines Batteriesystems anzugeben, das einen zuverlässigen Betrieb gewährleistet und durch Fehlerzustände ausgelöste Fehlfunktionen des Batteriesystems reduziert und somit die Verfügbarkeit des Batteriesystems erhöht.

Die Lösung der Aufgabe erfolgt durch ein Batteriesystem umfassend mehrere Batteriezellen, eine Steuerungs-Elektronikeinheit mit einem Steuerungsprozessor zur Steuerung des Batteriesystems, und zumindest eine Überwachungs-Elektronikeinheit mit einem Überwachungsprozessor zur Erfassung und Beeinflussung der Spannung zumindest einiger der Batteriezellen des Batteriesystems, wobei der Steuerungsprozessor mit dem Überwachungsprozessor über eine erste Kommunikationsverbindung kommunikationsverbunden ist, wobei der Überwachungsprozessor einen Abschalt-Pin zum Abschalten und/oder Rücksetzen des Überwachungsprozessors aufweist und der Überwachungsprozessor vom Steuerungsprozessor über den Abschalt-Pin abschaltbar und/oder rücksetzbar ist.

Erfindungsgemäß weist der Überwachungsprozessor einen Pin auf der dazu eingerichtet ist, den Überwachungsprozessor zuverlässig abzuschalten und/oder rückzusetzen, auch wenn beispielsweise die Verarbeitung von über ein Bussystem durch die erste Kommunikationsleitung geschickten Instruktionen durch den Überwachungsprozessor nicht mehr funktioniert. Ein Signal am Abschalt-Pin bewirkt daher direkt und/oder nur über einfache elektronische Bauteile vermittelt, ohne Nutzen der Steuerungslogik eines Mikroprozessors, ein Abschalten oder Rücksetzen des Überwachungsprozessors. Das Abschaltsignal kann vom Steuerungsprozessor gesetzt werden.

Erfindungsgemäß ist der Überwachungsprozessor über eine von der ersten Kommunikationsleitung verschiedene zweite Kommunikationsleitung, die mit dem Abschalt-Pin verbunden ist, über den Abschalt-Pin abschaltbar und/oder rücksetzbar. Die zweite Kommunikationsleitung ist insbesondere direkt mit dem Abschalt-Pin verbunden und dient insbesondere ausschließlich dazu, den Überwachungsprozessor über den Abschalt-Pin zu aktivieren oder auszuschalten oder rückzusetzen.

Unter "Abschalten" wird erfindungsgemäß ein Abschalten der Stromversorgung, also beispielsweise ein Trennen von der Stromversorgung verstanden, so dass der Überwachungsprozessor abschaltet.

Unter "Rücksetzen" wird erfindungsgemäß ein Löschen und/oder Zurücksetzen bestimmter Register des Überwachungsprozessors auf festgelegte Zustände verstanden.

Weiterbildungen der Erfindung sind in den abhängigen Ansprüchen, der Beschreibung sowie den beigefügten Zeichnungen angegeben.

Vorzugsweise ist der Überwachungsprozessor über den Abschalt-Pin auch einschaltbar, so dass je nach Signal am Abschalt-Pin der Überwachungsprozessor in Betrieb ist oder nicht.

Bevorzugt ist die erste Kommunikationsleitung mit einem Signaleingangs-Pin des Überwachungsprozessors verbunden. Üblicherweise weist eine Kommunikationsleitung zwischen dem Steuerungsprozessor und dem Überwachungsprozessor mehrere Leitungen auf, die mit jeweiligen Signaleingangs-Pins am Überwachungsprozessor verbunden sind. Der Abschalt-Pin ist bevorzugt ein zu den Signaleingangs-Pins zusätzlicher Pin am Überwachungsprozessor.

Gemäß einer Ausführungsform ist der Überwachungsprozessor durch einen ersten festgelegten Spannungsbereich am Signaleingangs-Pin über den Abschalt-Pin abschaltbar und/oder rücksetzbar. Die ohnehin zur Signalübertragung genutzte erste Kommunikationsleitung wird dann auch verwendet um den Abschalt-Pin zu aktivieren. Dabei wird jedoch nicht ein übliches Kommando über einen Kommunikations-Bus geschickt, sondern ein Spannungsbereich verwendet, der sich vom sonst genutzten Spannungsbereich unterscheidet, um eine sichere Übertragung der Abschalt- oder Rücksetz-Anforderung an den Abschalt-Pin zu gewährleisten.

Bevorzugt ist der Überwachungsprozessor durch einen zweiten festgelegten Spannungsbereich am Signaleingangs-Pin über den Abschalt-Pin auch einschaltbar. Je nach verwendetem Spannungsbereich am Signaleingangs-Pin ist dann der Überwachungsprozessor in Betrieb oder ausgeschaltet.

Bevorzugt ist der Überwachungsprozessor eingeschaltet, wenn am Abschalt-Pin ein dritter festgelegter Spannungsbereich anliegt und ist der Überwachungsprozessor abgeschaltet, wenn am Abschalt-Pin ein vierter festgelegter Spannungsbereich anliegt. Dabei kann der vierte Spannungsbereich bei im Wesentlichen null Volt liegen. Der Überwachungsprozessor kann daher bei anliegender Spannung in Betrieb sein und dadurch abgeschaltet werden, dass am Abschalt-Pin keine Spannung mehr anliegt.

Bevorzugt weist die erste Kommunikationsleitung und gegebenenfalls die zweite Kommunikationsleitung zwischen Steuerprozessor und Überwachungsprozessor zumindest je eine galvanische Trennung auf, bevorzugt je zwei, beispielsweise eine erste galvanische Trennung im Bereich des Ausgangs der Kommunikationsleitung an der Steuerungs-Elektronikeinheit und eine zweite galvanische Trennung vor dem Eingang zu einer Überwachungs-Elektronikeinheit. Die galvanische Trennung kann für die erste Kommunikationsleitung beispielsweise induktiv oder kapazitiv ausgebildet sein und für die zweite Kommunikationsleitung beispielsweise als Optokoppler ausgebildet sein.

Gemäß einer Ausführungsform kann der Überwachungsprozessor über den Abschalt-Pin vorübergehend, also beispielsweise nur kurzzeitig, abschaltbar sein, so dass der Überwachungsprozessor nach einer festgelegten Zeitspanne selbststätig wieder einschaltet. Auf diese Weise ist eine Art von Rücksetzung des Überwachungsprozessors durch nur eine Aktivierung des Abschalt-Pins umsetzbar.

Besonders bevorzugt umfasst ein erfindungsgemäßes Batteriesystem mehrere Überwachungs-Elektronikeinheiten mit jeweiligen Überwachungsprozessoren, die jeweils einen eigenen Abschalt-Pin zum Abschalten und/oder Rücksetzen des jeweiligen Überwachungsprozessors aufweisen. Die Überwachungsprozessoren sind dann vom Steuerungsprozessor über den jeweiligen Abschalt-Pin abschaltbar und/oder rücksetzbar. Insbesondere können alle Abschalt-Pins der Überwachungsprozessoren über eine gemeinsame zweite Kommunikationsleitung angesteuert werden und somit alle Überwachungsprozessoren gemeinsam und insbesondere gleichzeitig über die Abschalt-Pins abschaltbar und/oder rücksetzbar sein.

Bevorzugt ist der Steuerungsprozessor dazu eingerichtet, einen Fehlerzustand des Überwachungsprozessors zu erkennen und bei einem Batteriesystem mit mehreren Überwachungsprozessoren insbesondere auch dazu eingerichtet, zu erkennen, welcher der Überwachungsprozessoren einen Fehlerzustand aufweist.

Die Lösung der erfindungsgemäßen Aufgabe erfolgt auch durch ein Verfahren zur Steuerung eines Batteriesystem umfassend mehrere Batteriezellen, eine Steuerungs-Elektronikeinheit mit einem Steuerungsprozessor zur Steuerung des Batteriesystems, und zumindest eine Überwachungs-Elektronikeinheit mit einem Überwachungsprozessor zur Erfassung und Beeinflussung der Spannung von Batteriezellen des Batteriesystems, wobei der Steuerungsprozessor mit dem Überwachungsprozessor über eine erste Kommunikationsverbindung kommunikationsverbunden ist, durch den Steuerungsprozessor, wobei der Überwachungsprozessor einen Abschalt-Pin zum Abschalten und/oder Rücksetzen des Überwachungsprozessors aufweist und der Überwachungsprozessor vom Steuerungsprozessor über den Abschalt-Pin abgeschaltet oder rückgesetzt wird.

Der Überwachungsprozessor wird erfindungsgemäß über eine von der ersten Kommunikationsleitung verschiedene zweite Kommunikationsleitung über den Abschalt-Pin abgeschaltet oder rückgesetzt, insbesondere dadurch, dass an der zweiten Kommunikationsleitung und am Abschalt-Pin keine Spannung angelegt wird. Wenn eine Spannung bzw. ein vorbestimmter Spannungsbereich am Abschalt-Pin anliegt, kann der Überwachungsprozessor im Betrieb sein.

Insbesondere kann der Überwachungsprozessor über den Abschalt-Pin abgeschaltet oder rückgesetzt werden, wenn der Steuerungsprozessor einen Fehlerzustand des Überwachungsprozessors erkennt.

### Kurzbeschreibung der Zeichnungen

Die Erfindung wird im Folgenden beispielhaft unter Bezugnahme auf die Zeichnungen beschrieben.
- Fig. 1: ist eine schematische Darstellung eines erfindungsgemäßen Batteriesystems.
- Fig. 2: ist eine schematische Darstellung eines nicht erfindungsgemäßen Batteriesystems.
- Fig. 3: ist eine schematische Darstellung einer weiteren Ausführungsform eines nicht erfindungsgemäßen Batteriesystems.

### Detaillierte Beschreibung der Erfindung

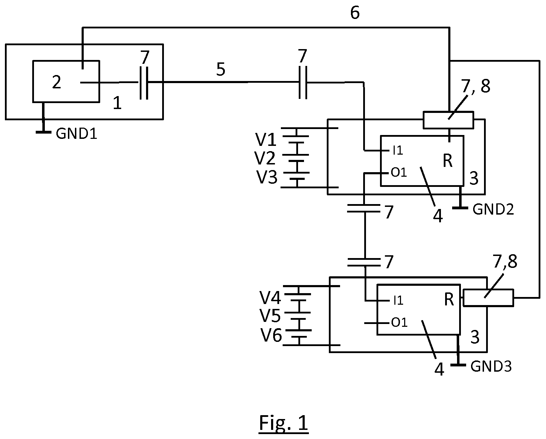

In Fig. 1 ist ein erfindungsgemäßes Batteriesystem dargestellt, mit mehrere Batteriezellen V1,..,V6, die in zwei Batteriemodulen V1,..,V3 und V4,..,V6 angeordnet sind. Jedem Batteriemodul ist eine Überwachungs-Elektronikeinheit 3 zugeordnet, mit je einem Überwachungsprozessor 4 zur Erfassung und Beeinflussung der Spannung der jeweils zugeordneten Batteriezellen V1,..,V3 bzw. V4,..,V6 des Batteriesystems. Eine Steuerungs-Elektronikeinheit 1 mit einem Steuerungsprozessor 2 dient zur Steuerung des gesamten Batteriesystems. Der Steuerungsprozessor 2 ist mit beiden Überwachungsprozessoren 4 über jeweils eine erste Kommunikationsverbindung 5 kommunikationsverbunden. Die erste Kommunikationsleitung 5 ist zumindest mit jeweils einem ersten Signaleingangs-Pin I1 verbunden. Das Signal kann über einen ersten Signalausgangs-Pin O1 an einen seriell nachgeschalteten Überwachungsprozessor 4 weitergeleitet werden um beispielsweise eine sogenannte "daisy-chain" von Überwachungsprozessoren auszubilden. In der Ausführungsform der Fig. 1 ist die erste Kommunikationsleitung 5 jedoch nicht mit dem Abschalt-Pin R verbunden. Vielmehr stellt eine zweite Kommunikationsleitung 6 eine direkte Verbindung zwischen dem Steuerungsprozessor 2 und den Abschalt-Pins R der beiden Überwachungsprozessoren 4 her. An der ersten Kommunikationsleitung 5, die über Spannungsverläufe kodierte Informationen tragen kann, sind galvanische Trennungen 7 beispielsweise in Form von induktiven oder kapazitiven Trennungen angeordnet, an der zweiten Kommunikationsleitung, an welcher ein Gleichspannungssignal anliegen oder nicht anliegen kann, ist als galvanische Trennung 7 jeweils ein Optokoppler 8 angeordnet. Der Steuerungsprozessor 2 und die Überwachungsprozessoren 4 können voneinander unterschiedliche Massepotentiale GND1, GND2, GND3 aufweisen.

Die Überwachungsprozessoren 4 sind vom Steuerungsprozessor 2 über deren Abschalt-Pins R abschaltbar. Je nach Spannungsniveau am Abschalt-Pin R ist der entsprechende Überwachungsprozessor 4 ein- oder ausgeschaltet. Zusätzlich oder in einer anderen Ausführungsform könnten die Überwachungsprozessoren 4 vom Steuerungsprozessor 2 über deren Abschalt-Pins R auch rücksetzbar sein.

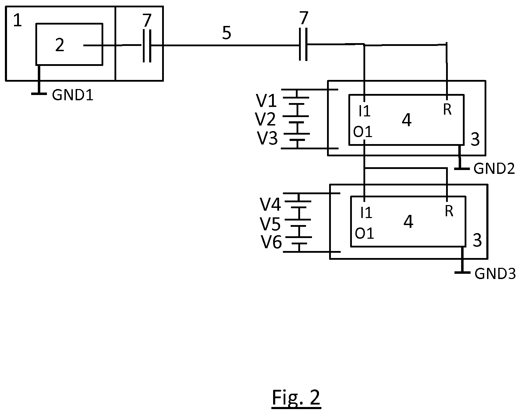

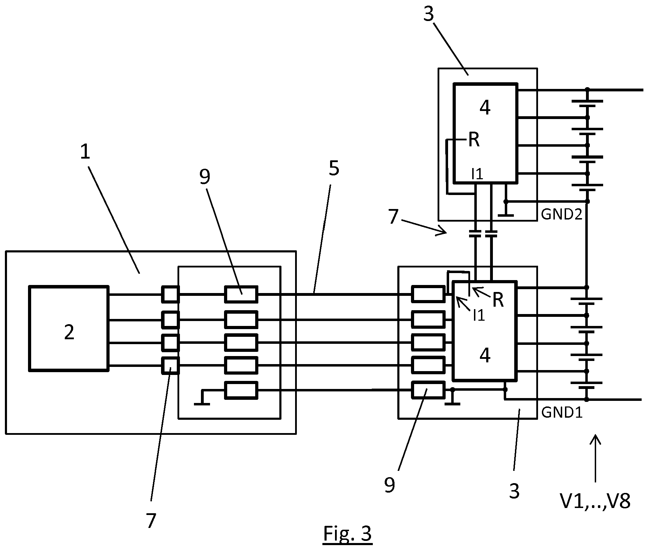

Die in Fig. 2 und Fig. 3 dargestellten Ausführungsformen unterscheiden sich von der Ausführung der Fig. 1 vor allem dadurch, dass sie keine separate zweite Kommunikationsleitung 6 zur Ansteuerung des Abschalt-Pins R verwenden, sondern die erste Kommunikationsleitung 5, wobei ein definiertes Spannungsniveau bzw. ein definierter Spannungsbereich an der ersten Kommunikationsleitung 5 vom Abschalt-Pin R als ein- und/oder Ausschaltsignal verwendet wird.

Wie in Fig. 3 dargestellt, wird eine Kommunikationsleitung zur Übertragung von Informationen zwischen dem Steuerungsprozessor 2 und einem Überwachungsprozessor 4 üblicherweise mehrere Leitungen umfassen, wovon im dargestellten Beispiel die erste Kommunikationsleitung 5 über Filterelemente 9 sowohl zum ersten Signaleingangs-Pin I1 als auch zum Abschalt-Pin R geführt ist.

Im Betrieb eines erfindungsgemäßen Batteriesystems gem. den Figuren Fig. 1 bis Fig. 3, werden die Überwachungsprozessoren 4 vom Steuerungsprozessor 2, wenn der Steuerungsprozessor 2 einen Fehlerzustand eines Überwachungsprozessors 4 erkennt, über den Abschalt-Pin R des jeweiligen Überwachungsprozessors 4 abgeschaltet. Nach einem Neustart des Überwachungsprozessors 4 oder aller Überwachungsprozessoren 4 ist der Fehlerzustand in der Regel behoben.

Die Erfindung gibt somit ein Batteriesystem und ein Verfahren zum Betrieb eines Batteriesystems an, das einen sicheren Betrieb des Batteriesystems gewährleistet und durch Fehlerzustände ausgelöste Fehlfunktionen mit Hilfe von Abschalt-Pins an den Überwachungsprozessoren des Batteriesystems reduziert.

### Bezugszeichenliste

- 1: Steuerungs-Elektronikeinheit
- 2: Steuerungsprozessor
- 3: Überwachungs-Elektronikeinheit
- 4: Überwachungsprozessor
- 5: erste Kommunikationsverbindung
- 6: zweite Kommunikationsleitung
- 7: galvanische Trennung
- 8: Optokoppler
- 9: Filter

- R: Abschalt-Pin
- V1,..,V8: Batteriezellen
- 11: Signaleingangs-Pin
- O1: Signalausgangs-Pin
- GND1: Massepotential
- GND2: Massepotential
- GND3: Massepotential

## Patentansprüche

1. Batteriesystem umfassend mehrere Batteriezellen (V1,..,V6), eine Steuerungs-Elektronikeinheit (1) mit einem Steuerungsprozessor (2) zur Steuerung des Batteriesystems, und zumindest eine Überwachungs-Elektronikeinheit (3) mit einem Überwachungsprozessor (4) zur Erfassung und Beeinflussung der Spannung zumindest einiger der Batteriezellen (V1,..,V6) des Batteriesystems, wobei der Steuerungsprozessor (2) mit dem Überwachungsprozessor (4) über eine erste Kommunikationsverbindung (5) kommunikationsverbunden ist,
wobei der Überwachungsprozessor (4) einen Abschalt-Pin (R) zum Abschalten und/oder Rücksetzen des Überwachungsprozessors (4) aufweist und der Überwachungsprozessor (4) vom Steuerungsprozessor (2) über den Abschalt-Pin (R) abschaltbar und/oder rücksetzbar ist, **dadurch gekennzeichnet, dass** der Überwachungsprozessor (4) über eine von der ersten Kommunikationsleitung (5) verschiedene zweite Kommunikationsleitung (6), die mit dem Abschalt-Pin (R) verbunden ist, über den Abschalt-Pin (R) abschaltbar und/oder rücksetzbar ist.

2. Batteriesystem nach Anspruch 1,
**dadurch gekennzeichnet, dass** der Überwachungsprozessor (4) über den Abschalt-Pin (R) einschaltbar ist.

3. Batteriesystem nach einem der Ansprüche 1 oder 2,
**dadurch gekennzeichnet, dass** die erste Kommunikationsleitung(5) mit einem Signaleingangs-Pin (I1) des Überwachungsprozessors (4) verbunden ist.

4. Batteriesystem nach zumindest einem der vorhergehenden Ansprüche,
**dadurch gekennzeichnet, dass** der Überwachungsprozessor (4) durch einen ersten festgelegten Spannungsbereich am Signaleingangs-Pin (I1) über den Abschalt-Pin (R) abschaltbar und/oder rücksetzbar ist.

5. Batteriesystem nach zumindest einem der vorhergehenden Ansprüche,
**dadurch gekennzeichnet, dass** der Überwachungsprozessor (4) durch einen zweiten festgelegten Spannungsbereich am Signaleingangs-Pin (I1) über den Abschalt-Pin (R) einschaltbar ist.

6. Batteriesystem nach zumindest einem der vorhergehenden Ansprüche,
**dadurch gekennzeichnet, dass** der Überwachungsprozessor (4) eingeschaltet ist, wenn am Abschalt-Pin (R) ein dritter festgelegter Spannungsbereich anliegt und dass der Überwachungsprozessor (4) abgeschaltet ist, wenn am Abschalt-Pin (R) ein vierter festgelegter Spannungsbereich anliegt, wobei insbesondere der vierte Spannungsbereich bei im Wesentlichen null Volt liegt.

7. Batteriesystem nach zumindest einem der vorhergehenden Ansprüche,
**dadurch gekennzeichnet, dass** die erste Kommunikationsleitung (5) und gegebenenfalls die zweite Kommunikationsleitung (6) zwischen Steuerprozessor (2) und Überwachungsprozessor (4) zumindest je eine galvanische Trennung (7) aufweist, bevorzugt je zwei.

8. Batteriesystem nach zumindest einem der vorhergehenden Ansprüche,
**dadurch gekennzeichnet, dass** der Überwachungsprozessor (4) über den Abschalt-Pin (R) vorübergehend abschaltbar ist, so dass der Überwachungsprozessor (4) nach einer festgelegten Zeitspanne selbststätig wieder einschaltet.

9. Batteriesystem nach zumindest einem der vorhergehenden Ansprüche,
**dadurch gekennzeichnet, dass** es mehrere Überwachungs-Elektronikeinheiten (3) mit Überwachungsprozessoren (4) umfasst, die jeweils einen Abschalt-Pin (R) zum Abschalten und/oder Rücksetzen des jeweiligen Überwachungsprozessors (4) aufweisen und die Überwachungsprozessoren (4) vom Steuerungsprozessor (2) über den jeweiligen Abschalt-Pin (R) abschaltbar und/oder rücksetzbar sind.

10. Batteriesystem nach Anspruch 9,
**dadurch gekennzeichnet, dass** alle Überwachungsprozessoren (4) über die zweite Kommunikationsleitung (6) über den jeweiligen Abschalt-Pin (R) abschaltbar und/oder rücksetzbar sind.

11. Batteriesystem nach zumindest einem der vorhergehenden Ansprüche,
**dadurch gekennzeichnet, dass** der Steuerungsprozessor (2) dazu eingerichtet ist, einen Fehlerzustand des Überwachungsprozessors (4) zu erkennen und bei einem Batteriesystem mit mehreren Überwachungsprozessoren (4), nach Anspruch 10, insbesondere auch dazu eingerichtet ist, zu erkennen, welcher der Überwachungsprozessoren (4) einen Fehlerzustand aufweist.

12. Verfahren zur Steuerung eines Batteriesystem umfassend mehrere Batteriezellen (V1,..,V6), eine Steuerungs-Elektronikeinheit (1) mit einem Steuerungsprozessor (2) zur Steuerung des Batteriesystems, und zumindest eine Überwachungs-Elektronikeinheit (3) mit einem Überwachungsprozessor (4) zur Erfassung und Beeinflussung der Spannung von Batteriezellen (V1,..,V6) des Batteriesystems, wobei der Steuerungsprozessor (2) mit dem Überwachungsprozessor (4) über eine erste Kommunikationsverbindung (5) kommunikationsverbunden ist, durch den Steuerungsprozessor (2),
wobei der Überwachungsprozessor (4) einen Abschalt-Pin (R) zum Abschalten und/oder Rücksetzen des Überwachungsprozessors (4) aufweist und der Überwachungsprozessor (4) vom Steuerungsprozessor (2) über
den Abschalt-Pin (R) abgeschaltet oder rückgesetzt wird,
**dadurch gekennzeichnet, dass** der Überwachungsprozessor (4) über eine von der ersten Kommunikationsleitung (5) verschiedene zweite Kommunikationsleitung (6) über den Abschalt-Pin (R) abgeschaltet oder rückgesetzt wird.

13. Verfahren nach Anspruch 12,
**dadurch gekennzeichnet, dass** der Überwachungsprozessor (4) über eine von der ersten Kommunikationsleitung (5) verschiedene zweite Kommunikationsleitung (6) über den Abschalt-Pin (R) abgeschaltet oder rückgesetzt wird, dadurch, dass an der zweiten Kommunikationsleitung (6) und am Abschalt-Pin (R) keine Spannung angelegt wird.

14. Verfahren nach Anspruch 12 oder 13,
**dadurch gekennzeichnet, dass**, wenn der Steuerungsprozessor (2) einen Fehlerzustand des Überwachungsprozessors (4) erkennt, der Überwachungsprozessor (4) über den Abschalt-Pin (R) abgeschaltet oder rückgesetzt wird.

## Claims

1. Battery system comprising a plurality of battery cells (V1, ..., V6), a control electronics unit (1) with a control processor (2) for controlling the battery system, and at least one monitoring electronics unit (3) with a monitoring processor (4) for detecting and influencing the voltage of at least some of the battery cells (V1, ..., V6) of the battery system, wherein the control processor (2) is communication-connected to the monitoring processor (4) by way of a first communication connection (5),
wherein the monitoring processor (4) has a switch-off pin (R) for switching off and/or resetting the monitoring processor (4), and the monitoring processor (4) can be switched off and/or reset by the control processor (2) via the switch-off pin (R), **characterized in that** the monitoring processor (4) can be switched off and/or reset via the switch-off pin (R) by way of a second communication line (6) which is different from the first communication line (5) and which is connected to the switch-off pin (R).

2. Battery system according to claim 1,
**characterized in that** the monitoring processor (4) can be switched on via the switch-off pin (R).

3. Battery system according to any of claims 1 or 2,
**characterized in that** the first communication line (5) is connected to a signal input pin (I1) of the monitoring processor (4).

4. Battery system according to at least one of the preceding claims,
**characterized in that** the monitoring processor (4) can be switched off and/or reset via the switch-off pin (R) by a first defined voltage range on the signal input pin (I1).

5. Battery system according to at least one of the preceding claims,
**characterized in that** the monitoring processor (4) can be switched on via the switch-off pin (R) by a second defined voltage range on the signal input pin (I1).

6. Battery system according to at least one of the preceding claims,
**characterized in that** the monitoring processor (4) is switched on when a third defined voltage range is applied to the switch-off pin (R), and **in that** the monitoring processor (4) is switched off when a fourth defined voltage range is applied to the switch-off pin (R), wherein in particular the fourth voltage range is around substantially zero volts.

7. Battery system according to at least one of the preceding claims,
**characterized in that** the first communication line (5) and optionally the second communication line (6) between the control processor (2) and the monitoring processor (4) has at least one galvanic isolation (7), preferably two.

8. Battery system according to at least one of the preceding claims,
**characterized in that** the monitoring processor (4) can be temporarily switched off via the switch-off pin (R) so that the monitoring processor (4) automatically switches on again after a defined period of time.

9. Battery system according to at least one of the preceding claims,
**characterized in that** it comprises a plurality of monitoring electronics units (3) with monitoring processors (4), which each have a switch-off pin (R) for switching off and/or resetting the respective monitoring processor (4), and the monitoring processors (4) can be switched off and/or reset by the control processor (2) via the respective switch-off pin (R).

10. Battery system according to claim 9,
**characterized in that** all monitoring processors (4) can be switched off and/or reset via the respective switch-off pin (R) by way of the second communication line (6).

11. Battery system according to at least one of the preceding claims,
**characterized in that** the control processor (2) is configured to recognize a fault condition of the monitoring processor (4) and, in a battery system comprising a plurality of monitoring processors (4), according to claim 10, in particular is also configured to recognize which of the monitoring processors (4) has a fault condition.

12. Method for controlling a battery system comprising a plurality of battery cells (V1, ..., V6), a control electronics unit (1) with a control processor (2) for controlling the battery system, and at least one monitoring electronics unit (3) with a monitoring processor (4) for detecting and influencing the voltage of battery cells (V1, ..., V6) of the battery system, wherein the control processor (2) is communication-connected to the monitoring processor (4) by way of a first communication connection (5), by the control processor (2),
wherein the monitoring processor (4) has a switch-off pin (R) for switching off and/or resetting the monitoring processor (4), and the monitoring processor (4) is switched off or reset by the control processor (2) via the switch-off pin (R), **characterized in that** the monitoring processor (4) is switched off or reset via the switch-off pin (R) by way of a second communication line (6) which is different from the first communication line (5).

13. Method according to claim 12,
**characterized in that** the monitoring processor (4) is switched off or reset via the switch-off pin (R) by way of a second communication line (6) which is different from the first communication line (5), **in that** no voltage is applied to the second communication line (6) and to the switch-off pin (R).

14. Method according to claim 12 or 13,
**characterized in that**, when the control processor (2) recognizes a fault condition of the monitoring processor (4), the monitoring processor (4) is switched off or reset via the switch-off pin (R).

## Revendications

1. Système de batterie comprenant plusieurs cellules de batterie (V1, .., V6), une unité électronique de commande (1) avec un processeur de commande (2) pour commander le système de batterie, et au moins une unité électronique de surveillance (3) avec un processeur de surveillance (4) pour détecter et influencer la tension d'au moins quelques-unes des cellules de batterie (V1,..,V6) du système de batterie, dans lequel le processeur de commande (2) est relié en communication au processeur de surveillance (4) par une première liaison de communication (5),
dans lequel le processeur de surveillance (4) comporte une broche de coupure (R) pour désactiver et/ou réinitialiser le processeur de surveillance (4), et le processeur de surveillance (4) est désactivable et/ou réinitialisable par le processeur de commande (2) via la broche de coupure (R), **caractérisé en ce que** le processeur de surveillance (4) est désactivable et/ou réinitialisable via la broche de coupure (R) sur une deuxième ligne de communication (6), différente de la première ligne de communication (5) et reliée à la broche de coupure (R).

2. Système de batterie selon la revendication 1, **caractérisé en ce que** le processeur de surveillance (4) est activable via la broche de coupure (R).

3. Système de batterie selon la revendication 1 ou 2, **caractérisé en ce que** la première ligne de communication (5) est reliée à une broche d'entrée de signal (I1) du processeur de surveillance (4).

4. Système de batterie selon au moins l'une des revendications précédentes, **caractérisé en ce que** le processeur de surveillance (4) est désactivable et/ou réinitialisable via la broche de coupure (R) dans une première plage de tension fixée sur la broche d'entrée de signal (I1).

5. Système de batterie selon au moins l'une des revendications précédentes, **caractérisé en ce que** le processeur de surveillance (4) est activable via la broche de coupure (R) dans une deuxième plage de tension fixée sur la broche d'entrée de signal (I1).

6. Système de batterie selon au moins l'une des revendications précédentes, **caractérisé en ce que** le processeur de surveillance (4) est activé si une troisième plage de tension fixée est appliquée sur la broche de coupure (R), et **en ce que** le processeur de surveillance (4) est désactivé si une quatrième plage de tension fixée est appliquée sur la broche de coupure (R), la quatrième plage de tension étant en particulier sensiblement proche de zéro Volt.

7. Système de batterie selon au moins l'une des revendications précédentes, **caractérisé en ce que** la première ligne de communication (5) et le cas échéant la deuxième ligne de communication (6) entre processeur de commande (2) et processeur de surveillance (4) présentent au moins chacune une séparation galvanique (7), préférentiellement deux.

8. Système de batterie selon au moins l'une des revendications précédentes, **caractérisé en ce que** le processeur de surveillance (4) est désactivable provisoirement via la broche de coupure (R), de sorte que le processeur de surveillance (4) est automatiquement réactivé après un intervalle temporel défini.

9. Système de batterie selon au moins l'une des revendications précédentes, **caractérisé en ce que** celui-ci comprend plusieurs unités électroniques de surveillance (3) à processeurs de surveillance (4), lesquelles comportent chacune une broche de coupure (R) pour la désactivation et/ou la réinitialisation du processeur de surveillance (4) correspondant, et les processeurs de surveillance (4) sont désactivables et/ou réinitialisables par le processeur de commande (2) via la broche de coupure (R) correspondante.

10. Système de batterie selon la revendication 9, **caractérisé en ce que** tous les processeurs de surveillance (4) sont désactivables et/ou réinitialisables sur la deuxième ligne de communication (6) via la broche de coupure (R) correspondante.

11. Système de batterie selon au moins l'une des revendications précédentes, **caractérisé en ce que** le processeur de commande (2) est prévu pour détecter un état d'erreur du processeur de surveillance (4) et est en particulier également prévu, avec un système de batterie à plusieurs processeurs de surveillance (4) selon la revendication 10, pour détecter lequel des processeurs de surveillance (4) présente un état d'erreur.

12. Procédé de commande d'un système de batterie comprenant plusieurs cellules de batterie (V1,..,V6), une unité électronique de commande (1) avec un processeur de commande (2) pour commander le système de batterie, et au moins une unité électronique de surveillance (3) avec un processeur de surveillance (4) pour détecter et influencer la tension des cellules de batterie (V1,..,V6) du système de batterie, le processeur de commande (2) étant relié en communication au processeur de surveillance (4) par une première liaison de communication (5),
dans lequel le processeur de surveillance (4) comporte une broche de coupure (R) pour désactiver et/ou réinitialiser le processeur de surveillance (4), et le processeur de surveillance (4) est désactivé et/ou réinitialisé par le processeur de commande (2) via la broche de coupure (R),
**caractérisé en ce que** le processeur de surveillance (4) est désactivé ou réinitialisé via la broche de coupure (R) sur une deuxième ligne de communication (6), différente de la première ligne de communication (5).

13. Procédé selon la revendication 12, **caractérisé en ce que** le processeur de surveillance (4) est désactivé ou réinitialisé via la broche de coupure (R) sur une deuxième ligne de communication (6), différente de la première ligne de communication (5), du fait qu'aucune tension n'est appliquée sur la deuxième ligne de communication (6) et sur la broche de coupure (R).

14. Procédé selon la revendication 12 ou 13, **caractérisé en ce que**, lorsque le processeur de commande (2) détecte un état d'erreur du processeur de surveillance (4), le processeur de surveillance (4) est désactivé ou réinitialisé via la broche de coupure (R).
